# EUROPEAN PATENT APPLICATION

(11) **EP 1 684 200 A1**
(43) Date of publication of application: **26.07.2006**
(21) Application number: 05250298.6
(22) Date of filing: 21.01.2005
(51) Int. Cl.: G06F 17/40, G11B 31/00, H04L 29/10, H04L 29/12, G11B 33/04

(54) **Data uploading device**

(71) Applicant: ORIGGIO LIMITED, Buckland, Hertfordshire SG9 0RU (GB)
(72) Inventor: Jamin, Jonathan Guillaume, Bury St. Edmunds Suffolk IP30 0QJ (GB)
(74) Representative: Brunner, Michael John

(57) **Abstract**

An apparatus is provided for uploading digital data to a memory mounted on a support, the support having an input through which the data can be uploaded to the memory, the apparatus comprising: a housing; a slot in the housing for receiving the support in a predetermined position; a set of upload contacts in the housing, movable between a first position when the support is not in the predetermined position and a second position when the support is in the predetermined position and in which the set of upload contacts is in contact with the memory input; whereby the data can be transmitted through the upload contacts to the memory input when the upload contacts are in contact with the input on the support.

## Description

The present invention relates to an apparatus and method for uploading data onto a memory mounted on a support. In particular, the invention relates to an apparatus, into which a support on which the memory has previously been mounted, for example attached to a PCB, can be inserted so that data can be uploaded to the memory quickly, easily and simply.

The invention is particularly designed for uploading audio data onto a packaging container such as disclosed in our application WO 03/065375.

It is an aim of the present invention to provide an apparatus into a which a memory can be easily inserted in order to upload data onto the memory .

According to the present invention there is provided an apparatus for uploading digital data to a memory mounted on a support, the support having an input through which the data can be uploaded to the memory, the apparatus comprising:
a housing;
a slot in the housing for receiving the support in a predetermined position;
a set of upload contacts in the housing, movable between a first position when the support is not in the predetermined position and a second position when the support is in the predetermined position and in which the set of upload contacts is in contact with the memory input;
whereby the data can be transmitted through the upload contacts to the memory input when the upload contacts are in contact with the input on the support.

The slot may be arranged to receive a support in the form of a CD or DVD insert tray.

Preferably, the memory is flash memory.

The apparatus may further comprising a movable carriage provided in the housing arranged to receive the support.

According to a second aspect of the present invention there is provided a method for uploading digital data to a memory mounted on a support, the support having an input through which the data can be uploaded to the memory and the apparatus comprising a housing and a slot in the housing; the method comprising the steps of:
moving the support into the slot to a predetermined position;
moving a set of upload contacts in the housing from a first position when the support is not in the predetermined position to a second position when the support is in the predetermined position and in which the set of upload contacts is in contact with the memory input;
transmitting the data through the upload contacts to the memory input when the upload contacts are in contact with the input on the support.

An example of the apparatus according to the invention will now be described with reference to the accompanying drawings, in which:
Figure 1 is an isometric view of a support for a CD jewel case.
Figure 2 is an isometric view of the apparatus according to the invention.
Figure 3 is a cross-sectional view of the apparatus according to the invention.
Figure 4 is an isometric view of the apparatus with a portion of its housing removed.

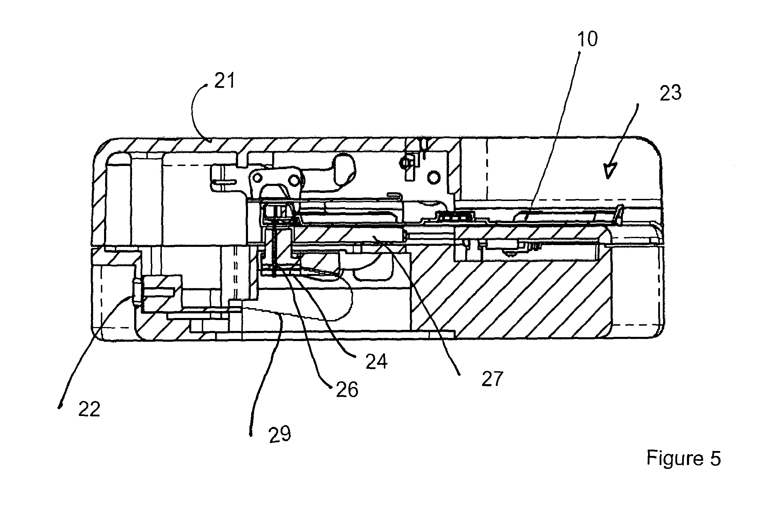

Figure 5 is a cross-sectional view of the apparatus according to the invention.

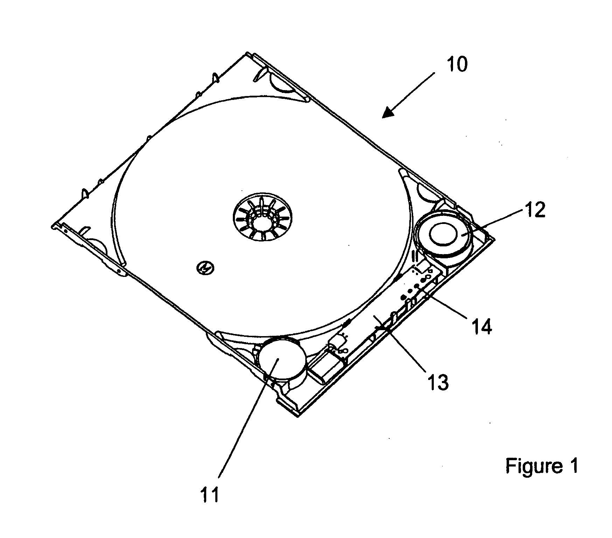

A support tray 10 for a CD jewel case (not shown) is displayed in Figure 1. The tray 10 has mounted to it, substantially along one edge, a speaker 12, a PCB 13 and a battery 11 for supplying power thereto. The PCB has attached to it a flash memory in which one or more sets of audio data can be stored. A button (not shown) is mounted on the PCB (on the far side to that which can be seen in the figure) and when it is actuated, the speaker plays the audio data stored in the flash memory. Connected to the PCB is a set of input contacts 14, through which the audio data can be uploaded to the flash memory. Although this description relates to uploading data onto a memory in a CD jewel case, the invention is not limited to this specific application.

As described in our WO 03/065375, samples of audio data can be stored in the flash memory. A user, on a PC creates a compilation of audio files that are required to be stored in the flash memory for future playing. This compilation may be compressed to a suitable size for the flash memory, the first stage of the process being to convert the raw audio data, which is in WAV or MP3 stereo, in a number of different frequencies, into mono at a frequency of 8Khz. This is achieved by Pulse Code Modulation (PCM). The PCM data is then compressed further by standard ADPCM, Adaptive Differential PCM. A piece of software then sends the compressed compilation, via a cable to the apparatus of the invention which will upload the data into the flash memory.

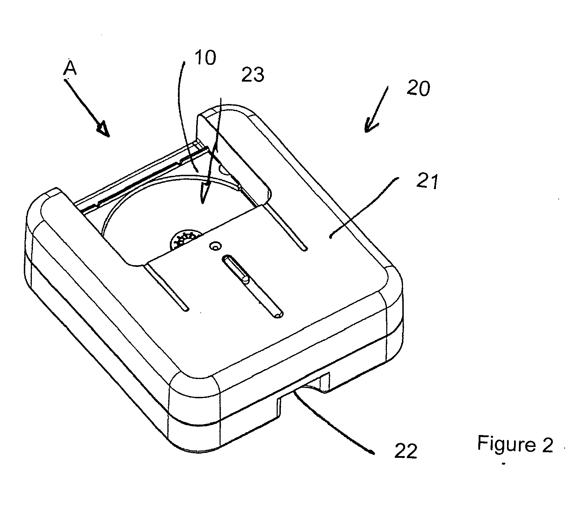

Figure 2 shows an apparatus 20 for uploading the digital audio data onto the flash memory. The apparatus comprises a housing or body 21 into which the support tray 10 can be inserted from one end in the direction of arrow A. A terminal or port 22, which in this example is a USB port, is provided in the housing 21 to allow the apparatus to be connected to a PC (not shown) via a suitable cable (not shown) so that the audio data can be transferred to the flash memory in the tray 10. Within the housing 21 is a set of upload contacts 26 which connects, in use, to the set of input contacts 14 provided on the PCB 13.

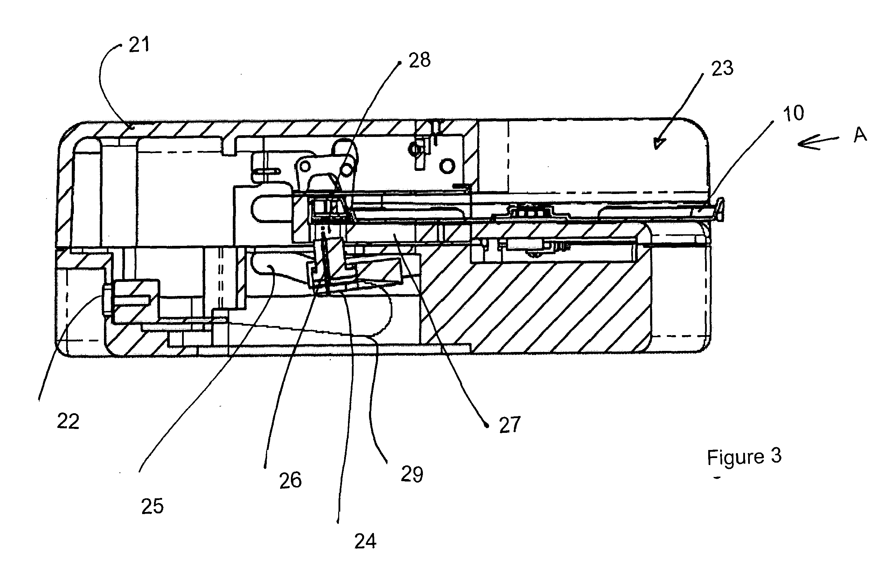

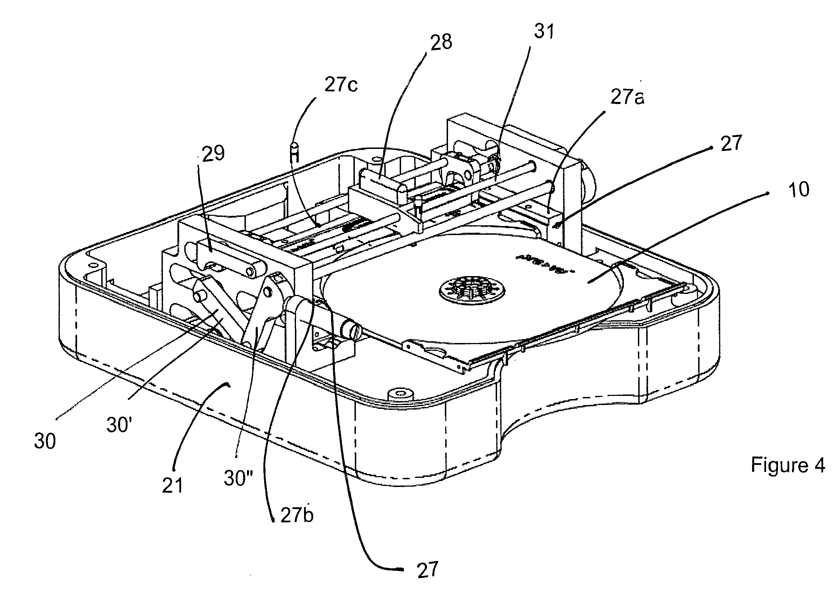

Figure 3 shows a cross section of the apparatus 20 when the tray 10 is partially inserted into the housing 21. The tray 10 is inserted into the housing 21 such that the edge of the tray on which the input contacts 14 (on the PCB 13) are located is received in the housing first and the input contacts 14 face downwards. The tray 10 is first received in an insertion slot 23 and pushed into the housing body 21 by the user (in the direction from right to left in Figure 3). The tray 10 is then received in a carriage 27 which encloses the side and bottom surfaces of the tray 10 as seen in Figure 3. Figure 4 (which shows the apparatus with the top half of the housing removed) shows the carriage 27 and the tray 10 having been partially inserted into the housing 21. The carriage encloses the tray 10 on three sides by three walls indicated by 27a, 27b and 27c. The bottom of the tray, which is hidden in Figure 4 is also supported.

The carriage 27 is arranged such that when the tray 10 is pushed further into the housing 21 it makes contact with wall 27c of the carriage so that the carriage moves with the tray 10. Adjacent the position at which the input contacts 14 are received on the carriage 27 is an aperture 28 through the carriage, so that the input contacts 14 are accessible from the lower side of the carriage.

The USB port 22 is connected to a PCB (not shown) mounted in the housing. The audio data is received from the PC in USB data format and this needs to be converted to a serial format for the flash memory on the tray 10. This is achieved by a serial peripheral interface on the PCB which is powered from the USB cable itself. The PCB is connected by a ribbon cable 29 to a set of upload contacts 26 which connect to the input contacts 14, so that the data can be transferred from a PC, to the flash memory via the input USB port 22, the upload contacts 26 and the input contacts 14. The set of upload contacts 26 are provided on a contact block 24 which is connected to the carriage 27 such that when the carriage moves into the housing, the contact block also moves within the housing. The upload contacts 26 are simple spring contacts, which are pushed against the input contacts 14 on the tray 10 to make an electrical connection for the data to be uploaded to the flash memory. The contact block 24 moves when the carriage 27 is pushed into the housing 21 along a cam profile 25 such that when the tray 10 is pushed into the housing 21 the contact block 24 is deflected upwards towards the tray 10 and into the aperture 28 so that the upload contacts 26 connect with the input contacts 14.

As seen in Figure 4, when the insert tray 10 has been fully inserted into the housing 21, the contact block 24 is pushed against the tray 10 and in particular the set of input contacts 14. The carriage is held in the fully inserted position so that it cannot move until released by the user (explained below). In this position, the data can be uploaded via the input terminal 22 and the set of contacts 26 to the flash memory on the tray 10.

The uploading of the data to the single CD tray 10 takes about 5 seconds. The apparatus 20 receives power from the USB input lead to provide power for a status indicator (not shown) which displays when the data has been up loaded to the flash memory or if the data has not been loaded into the flash memory successfully for some reason. An audio and/or visual signal on the computer or on the apparatus 20 notifies the user that the upload is complete.

The tray 10 is retained in the housing 21 by a tray retention arm 30, which as seen in Figure 4 is comprised of two segments 30', 30" which are pivotally connected to form an "over-centre" mechanism. One segment 30' is connected to the movable carriage 27 and the other segment 30" is fixed to the housing 21. When the tray 10 is fully inserted into the housing 21, the arm 30 is straight and locks by virtue of the over-centre operation of the arm 30, holding the carriage 27 in the housing so that the tray 10 cannot be pulled out from the housing.

Once the upload has been completed the tray 10 can be removed from the housing 21 by pressing an eject button 28 which is connected to a release arm 29 by a connecting rod 31. When the eject button 28 is pressed, the release arm 29 rotates downwards and pushes the tray retention arm 30 out of the over-centre position. This releases the carriage 27 which contains the tray 10 allowing it to be removed. The contact block 24 retracts from the aperture 28 when the carriage is released and the tray can be removed from the insertion slot 23.

## Claims

1. An apparatus for uploading digital data to a memory mounted on a support, the support having an input through which the data can be uploaded to the memory, the apparatus comprising:
a housing;
a slot in the housing for receiving the support in a predetermined position;
a set of upload contacts in the housing, movable between a first position when the support is not in the predetermined position and a second position when the support is in the predetermined position and in which the set of upload contacts is in contact with the memory input;
whereby the data can be transmitted through the upload contacts to the memory input when the upload contacts are in contact with the input on the support.

2. An apparatus according to claim 1, wherein the slot is arranged to receive a support in the form of a CD or DVD insert tray.

3. An apparatus according to claim 1, further comprising a movable carriage provided in the housing arranged to receive the support.

4. A method for uploading digital data to a memory mounted on a support, the support having an input through which the data can be uploaded to the memory and the apparatus comprising a housing and a slot in the housing; the method comprising the steps of:
moving the support into the slot to a predetermined position;
moving a set of upload contacts in the housing from a first position when the support is not in the predetermined position to a second position when the support is in the predetermined position and in which the set of upload contacts is in contact with the memory input;
transmitting the data through the upload contacts to the memory input when the upload contacts are in contact with the input on the support.
